# EUROPÄISCHE PATENTSCHRIFT

(11) **EP 2 153 188 B1**
(45) Veröffentlichungstag und Bekanntmachung des Hinweises auf die Patenterteilung: **16.05.2012**
(21) Anmeldenummer: 08758830.7
(22) Anmeldetag: 28.05.2008
(51) Int. Cl.: G01J 5/34, G01J 5/10, H01L 27/16, H01L 31/0203

(54) **VORRICHTUNG MIT SANDWICHSTRUKTUR ZUR DETEKTION VON WÄRMESTRAHLUNG, VERFAHREN ZUM HERSTELLEN UND VERWENDUNG DER VORRICHTUNG**
DEVICE HAVING A SANDWICH STRUCTURE FOR DETECTING THERMAL RADIATION, METHOD OF PRODUCTION AND USE OF THE DEVICE
DISPOSITIF À STRUCTURE EN SANDWICH CONÇU POUR DÉTECTER UN RAYONNEMENT THERMIQUE, PROCÉDÉ DE FABRICATION ET UTILISATION DU DISPOSITIF

(30) Priorität: 29.05.2007 DE 102007024903
(43) Veröffentlichungstag der Anmeldung: 17.02.2010
(73) Patentinhaber: Pyreos Ltd., EH9 3JF Edinburgh (GB)
(72) Erfinder: GIEBELER, Carsten, Edinburgh EH4 6HD (DE); SCHREITER, Matthias, 81379 München (DE); ZAPF, Jörg, 81927 München (DE)
(74) Vertreter: Fischer, Ernst
(86) Internationale Anmeldenummer: PCT/EP2008/004247
(87) Internationale Veröffentlichungsnummer: WO 2008/145354

(56) Entgegenhaltungen:
- EP-A- 0 453 372
- EP-A- 1 640 333
- WO-A1-2007/000172
- US-A1- 2004 173 751

## Beschreibung

Die Erfindung betrifft eine Vorrichtung zur Detektion von Wärmestrahlung mit mindestens einem thermischen Detektorelement zur Umwandlung der Wärmestrahlung in ein elektrisches Signal. Neben der Vorrichtung werden ein Verfahren zur Herstellung der Vorrichtung und eine Verwendung der Vorrichtung angegeben.

Eine Vorrichtung zur Detektion von Wärmestrahlung ist beispielsweise aus DE 100 04 216 A1 bekannt. Diese Vorrichtung wird als Pyrodetektor bezeichnet. Das Detektorelement ist ein pyroelektrisches Detektorelement. Es weist einen Schichtaufbau mit zwei Elektrodenschichten und einer zwischen den Elektrodenschichten angeordneten pyroelektrischen Schicht mit pyroelektrisch sensitivem Material auf. Dieses Material ist Bleizirkonattitanat (PZT). Die Elektroden bestehen beispielsweise aus Platin oder aus einer die Wärmestrahlung absorbierenden Chrom-Nickel-Legierung.

Das thermische Detektorelement ist mit einem Detektorträger aus Silizium(Silizium-Wafer) verbunden. Zwischen dem Detektorelement und dem Detektorträger ist eine Isolationsschicht zur elektrischen und thermischen Isolierung des Detektorelements und des Detektorträgers voneinander angeordnet. Die Isolationsschicht verfügt dabei über einen evakuierten Hohlraum, der sich über eine Grundfläche des Detektorelements hinweg erstreckt, eine Stützschicht des Hohlraums und eine Abdeckung der Stützschicht und des Hohlraums. Die Stützschicht besteht aus Polysilizium. Die Abdeckung ist aus einem Bor-Phosphor-Silikat-Glas (BPSG). Zum Auslesen, Verarbeiten und/oder Weiterleiten des vom Detektorelement erzeugten elektrischen Signals ist im Detektorträger ein Ausleseschaltkreis integriert. Der Ausleseschaltkreis ist durch die CMOS (Complementary Metalloxide Semiconductors)-Technik realisiert.

Eine damit vergleichbare Vorrichtung zur Detektion von Wärmestrahlung ist aus der DE 195 25 071 A1 bekannt. Das thermische Detektorelement ist ebenfalls ein oben beschriebenes pyroelektrisches Detektorelement. Das Detektorelement ist auf einem mehrschichtigen Detektorträger angeordnet. Über eine seiner Elektrodenschichten ist das Detektorelement auf einer Siliziumschicht des Detektorträgers aufgebracht. Die Siliziumschicht befindet sich auf einer elektrisch isolierenden Membran des Detektorträgers. Die Membran besteht beispielsweise aus einer Si₃N₄/SiO₂/Si₃N₄ - Dreifach-Schicht. Die Membran ist wiederum auf einem Silizium-Substrat des Detektorträgers aufgebracht. Das Silizium-Substrat weist ein Bestrahlungsfenster (Detektionsfenster) auf mit einer Grundfläche, die im Wesentlichen einer Grundfläche des pyroelektrischen Detektorelements entspricht. Das Bestrahlungsfenster ist ein Ausschnitt des Silizium-Substrats. Dabei ist Trägermaterial (Silizium) des Substrats bis zur Membran hin entfernt. Durch das Bestrahlungsfenster gelangt die Wärmestrahlung auf das Detektorelement und führt dort zu einem auswertbaren elektrischen Signal. Dazu zeichnet sich die Membran durch eine geeignete Transmission für die Wärmestrahlung aus. In der Siliziumschicht, seitlich zum Detektorelement versetzt, ist ein Ausleseschaltkreis für das elektrische Signal integriert. Der Detektorträger fungiert auch als Schaltungsträger des Ausleseschaltkreises.

Bei den bekannten Vorrichtungen kann eine Vielzahl von Detektorelementen vorhanden sein (Detektorelement-Array). Dabei ist das elektrische Signal jedes der Detektorelemente separat auszulesen. Üblicherweise sind dazu die Elektrodenschichten jedes der Detektorelemente über Bonddrähte elektrisch kontaktiert. Dies bedeutet aber einen erheblichen Platzbedarf für eine Verdrahtung der Detektorelemente mit dem Ergebnis einer begrenzten, relativ niedrigen Detektorelement-Dichte (Anzahl der Detektorelemente pro Oberflächenabschnitt des Detektorträgers).

In US 2004/0173751 A1 ist ein Infrarotsensor mit einem Siliziumsubstrat und einem Kappenkörper beschrieben, wobei zwischen dem Siliziumsubstrat und dem Kappenkörper ein Silikonoxidfilm aufgespannt ist, auf dem Widerstandskörper angebracht sind. Ferner ist in EP 0 453 372 A1 ein Infrarotsensor beschrieben, der ein Terminal-Substrat und ein Sensorsubstrat aufweist, zwischen denen ein Silikonoxidfilm aufgespannt ist, an dem ein Detektorelement angebracht ist.

WO 2007 000 172 beschreibt einen weiteren bekannten Infrarotsensor.

Aufgabe der Erfindung ist es, eine kompakte Vorrichtung zur Detektion von Wärmestrahlung anzugeben, die einen im Vergleich zum Stand der Technik geringeren Platzbedarf aufweist.

Zur Lösung der Aufgabe wird eine Vorrichtung zur Detektion von Wärmestrahlung angegeben, aufweisend einen Stapel mit mindestens einem Detektorträger mit mindestens einem thermischen Detektorelement zur Umwandlung der Wärmestrahlung in ein elektrisches Signal, mindestens einem Schaltungsträger mit mindestens einer Ausleseschaltung zum Auslesen des elektrischen Signals, wobei die Ausleseschaltung durch CMOS-Technik direkt im Schaltungsträger integriert ist, und mindestens einer Abdeckung zum Abdecken des Detektorelements, wobei der Detektorträger und der Schaltungsträger und/oder der Detektorträger und die Abdeckung jeweils durch einen hermetischen Stoffschluss fest miteinander verbunden sind, sodass der Detektorträger und die Abdeckung derart aneinander angeordnet sind, dass zwischen dem Detektorelement des Detektorträgers und der Abdeckung mindestens ein, vom Detektorträger und von der Abdeckung begrenzter, erster Stapelhohlraum des Stapels vorhanden ist, der Schaltungsträger und der Detektorträger derart aneinander angeordnet sind, dass zwischen dem Detektorträger und dem Schaltungsträger mindestens ein, vom Schaltungsträger und vom Detektorträger begrenzter, zweiter Stapelhohlraum des Stapels vorhanden ist und der jeweils ein Silizium-Substrat als die Abdeckung, als der Schaltungsträger und als der Detektorträger verwendet ist, der Detektorträger zwischen dem Schaltungsträger und der Abdeckung angeordnet ist und der Stapel eine Sandwich-Struktur aus dem Detektorträgers, dem Schaltungsträger und der Abdeckung hat, sowie erste Stapelhohlraum und/oder der zweite Stapelhohlraum evakuiert sind.

Zur Lösung der Aufgabe wird auch ein Verfahren zum Herstellen einer Vorrichtung zur Detektion von Wärmestrahlung mit folgenden Verfahrensschritten angegeben: a) Bereitstellen mindestens eines Detektorträgers mit mindestens einem thermischen Detektorelement zur Umwandlung der Wärmestrahlung in ein elektrisches Signal, Bereitstellen mindestens eines Schaltungsträgers mit mindestens einer Ausleseschaltung zum Auslesen des elektrischen Signals, wobei die Ausleseschaltung durch CMOS-Technik direkt im Schaltungsträger integriert ist, und Bereitstellen mindestens einer Abdeckung zum Abdecken des Detektorelements, wobei jeweils ein Silizium-Substrat als die Abdeckung, als der Schaltungsträger und als der Detektorträger verwendet wird, b) festes Verbinden des Detektorträgers, des Schaltungsträgers und der Abdeckung zu einem Stapel, wobei der Detektorträger zwischen dem Schaltungsträger und der Abdeckung angeordnet wird, wobei der Stapel eine Sandwich-Struktur aus dem Detektorträger, dem Schaltungsträger und der Abdeckung hat und zum festen Verbinden des Detektorträgers und des Schaltungsträgers und/oder zum festen Verbinden des Detektorträgers und der Abdeckung ein hermetischer Stoffschluss hergestellt wird, der Detektorträger und die Abdeckung derart aneinander angeordnet sind, dass zwischen dem Detektorelement des Detektorträgers und der Abdeckung mindestens ein, vom Detektorträger und von der Abdeckung begrenzter, erster Stapelhohlraum des Stapels vorhanden ist, der Schaltungsträger und der Detektorträger derart aneinander angeordnet sind, dass zwischen dem Detektorträger und dem Schaltungsträger mindestens ein, vom Schaltungsträger und vom Detektorträger begrenzter, zweiter Stapelhohlraum des Stapels vorhanden ist, wobei während und/oder nach dem festen Verbinden der erste Stapelhohlraum und/oder der zweite Stapelhohlraum evakuiert sind.

Durch die Erfindung wird eine kompakte, Platz sparende "Sandwich"-Struktur aus Detektorträger, Schaltungsträger und Abdeckung realisiert. Durch die Abdeckung ist das Detektorelement vor einem schädlichen Umwelteinfluss geschützt. Der Umwelteinfluss ist beispielsweise Staub, Luftfeuchtigkeit oder eine ätzende Chemikalie, die einen Bestandteil des Detektorelements angreifen oder die Funktionsweise des Detektorelementsbeeinträchtigenwürde. Der Auswerteschaltkreis kann direkt im Schaltungsträger integriert sein, beispielsweise durch die CMOS-Technik. Denkbar ist auch, dass der Schaltungsträger lediglich eine Verdrahtung des Detektorelements bereitstellt. Durch die Verdrahtung ist das Detektorelement mit einem im Schaltungsträger angeordneten internen ASIC (Applied Specific Integrated Circuit, anwendungsspezifische integrierte Schaltung) oder mit einem externen ASIC elektrisch verbunden.
Das externe ASIC kann gebondet sein. Vorteilhaft ist das externe ASIC mittels "Flip Chipl"-Technik (siehe unten) kontaktiert. Die Stapelhohlräume sorgen dafür, dass das Detektorelement von dem Schaltungsträger und der Abdeckung thermisch weitgehend voneinander entkoppelt sind.

Die zu detektierende Wärmestrahlung weist eine Wellenlänge von über 1 µm auf. Vorzugsweise ist die Wellenlänge aus dem Bereich von 5 bis 15 µm ausgewählt. Das thermische Detektorelement basiert beispielsweise auf dem Seebeck-Effekt. Vorzugsweise ist das thermische Detektorelement ein pyroelektrisches Detektorelement. Das pyroelektrische Detektorelement besteht, wie eingangs beschrieben, aus einer pyroelektrischen Schicht mit einem pyroelektrisch sensitiven Material und beidseitig angebrachten Elektrodenschichten. Das pyroelektrisch sensitive Material ist beispielsweise eine Keramik wie Lithiumniobat (LiNbO₃) oder Bleizirkonattitanat. Denkbar ist auch ein ferroelektrisches Polymer wie Polyvinylidenfluorid (PVDF). Als Elektrodenmaterial der Elektrodenschichten kommt beispielsweise Platin oder eine Platinlegierung in Frage. Denkbar ist auch eine Chrom-Nickel-Elektrode oder eine Elektrode aus einem elektrisch leitenden Oxid. Das Detektorelement verfügt beispielsweise über eine rechteckige Grundfläche mit einer Kantenlänge von 25 µm bis 200 µm.

Unabhängig vom Effekt, der zur Detektion der Wärmestrahlung ausgenutzt wird, ist eine Absorption der Wärmestrahlung durch jeweils ein den entsprechenden Effekt auslösendes, thermisch sensitives Material des Detektorelements notwendig. Die Absorption erfolgt direkt durch das thermisch sensitive Material. Denkbar ist aber auch, dass die Wärmestrahlung durch eine Elektrode bzw. Elektrodenschicht des Detektorelements absorbiert wird. Zudem ist es auch möglich, dass die Wärmestrahlung durch einen Absorptionsgegenstand in unmittelbarer Nähe des Detektorelements absorbiert und eine dadurch aufgenommene Wärmemenge durch Konvektion oder Wärmeleitung an das thermisch sensitive Material abgegeben wird. Der Absorptionsgegenstand fungiert als Energietransmitter. Beispielsweise ist der Absorptionsgegenstand als Beschichtung direkt auf das Detektorelement aufgebracht.

Der Stapel der Vorrichtung zur Detektion der Wärmestrahlung ist vorzugsweise derart ausgestaltet, dass die Wärmestrahlung direkt auf das Detektorelement gelangt. Dazu weisen in einer besonderen Ausgestaltung der Detektorträger, der Schaltungsträger und/oder die Abdeckung mindestens ein Bestrahlungsfenster mit einer bestimmten Transmission für die Wärmestrahlung zum Bestrahlen des Detektorelements mit der Wärmestrahlung auf. Das Bestrahlungsfenster ist in der Abdeckung, im Detektorträger und/oder im Schaltungsträger integriert. Das Detektorelement und das Bestrahlungsfenster sind derart aneinander angeordnet, dass die Bestrahlung des Detektorelements von einer dem Detektorträger abgewandten Vorderseite des Detektorelements (Vorderseitenbestrahlung) und/oder von einer dem Detektorträger zugewandten Rückseite des Detektorelements (Rückseitenbestrahlung) erfolgt. Das Bestrahlungsfenster weist in Richtung des Detektionselements eine bestimmte Transmission auf. Die Transmission ist möglichst hoch und beträgt beispielsweise über 50% und insbesondere über 70% bis nahe 95%.

Als Material des Detektorträgers, des Schaltungsträgers und der Abdeckung kommen beliebige Materialien in Frage. Halbleitende Materialien, beispielsweise elementares Germanium oder verschiedene halbleitende Verbindungen eignen sich wegen der Möglichkeit der Integration von elektrischen Schaltungen oder Bauteilen besonders. Gemäß einer besonderen Ausgestaltung weisen der Detektorträger, der Schaltungsträger und/oder die Abdeckung Silizium auf. Es wird jeweils ein Silizium-Substrat als Abdeckung, als Schaltungsträger und als Detektorträger verwendet. Durch die CMOS-Technik können beliebige Strukturen und Funktionalitäten in die Substrate integriert werden. Da Silizium bezüglich der Wärmestrahlung einen niedrigen Absorptionskoeffizienten aufweist, kann zudem das Bestrahlungsfenster sehr leicht in einem Silizium-Substrat integriert werden: Das Silizium-Substrat selbst bildet das Bestrahlungsfenster. Durch eine geeignete Anordnung der entsprechenden Funktionalitäten im Silizium-Substrat wird dafür gesorgt, dass die Wärmestrahlung ungehindert, also ohne Abschattung, auf das Detektorelement gelangt.

Die Transmission hängt nicht nur vom Absorptionskoeffizienten des Materials ab, aus dem das Bestrahlungsfenster besteht. Entscheidend ist auch eine Dicke des Bestrahlungsfensters. Vorteilhaft wird das Bestrahlungsfenster von einem ausgedünnten Bereich des Detektorträgers oder des Schaltungsträgers gebildet. In einer besonderen Ausgestaltung ist das Detektorelement gegenüber einer Schaltungsträgerausnehmung des Schaltungsträgers oder gegenüber einer Abdeckungsausnehmung der Abdeckung angeordnet. Die Schaltungsträgerausnehmung und die Abdeckungsausnehmung sind jeweils ein Bereich des Schaltungsträgers bzw. der Abdeckung mit relativ niedriger Dicke. In diesen Bereichen sind der Schaltungsträger und die Abdeckung ausgedünnt, beispielsweise durch Materialabtrag. Die Ausnehmungen bilden das Bestrahlungsfenster, das im Schaltungsträger bzw. in der Abdeckung integriert ist und durch das die Wärmestrahlung auf das Detektorelement gelangt. Das Detektorelement ist vorzugsweise von der jeweiligen Ausnehmung beabstandet. Die Abdeckungsausnehmung ist Bestandteil des ersten Stapelhohlraums zwischen dem Detektorträger und der Abdeckung. Die Schaltungsträgerausnehmung ist Bestandteil des zweiten Stapelhohlraums zwischen dem Detektorträger und dem Schaltungsträger.

In einer besonderen Ausgestaltung sind der Detektorträger und der Schaltungsträger und/oder der Detektorträger und die Abdeckung durch einen hermetischen Stoffschluss fest miteinander verbunden. Zum festen Verbindendes Detektorträgers und des Schaltungsträgers und/oder zum festen Verbinden des Detektorträgers und der Abdeckung wird ein Stoffschluss hergestellt. Der Stoffschluss ist derart ausgestaltet, dass die evakuierbaren Stapelhohlräume gebildet werden. Komponenten des Stapels, die sich in den Stapelhohlräumen befinden, beispielsweise das Detektorelement, sind durch den hermetischen Stoffschluss von einer Umgebung abgeschirmt. Es findet kein Stoffaustausch mit der Umgebung statt. Somit kann die Vorrichtung auch in einer aggressiven Umgebung eingesetzt werden. Durch den hermetischen Stoffschluss können die Stapelhohlräume evakuiert werden. Dies erhöht die Sensitivität gegenüber der zu detektierenden Wärmestrahlung.

Die Stoffschlüsse zwischen dem Detektorträger und der Abdeckung und zwischen dem Detektorträger und dem Schaltungsträger können nacheinander oder gleichzeitig hergestellt werden.

Der jeweilige Stoffschluss kann von einem beliebigen Stoff, beispielsweise einem Klebstoff gebildet werden. Besonders vorteilhaft ist es, mit dem Stoffschluss gleichzeitig eine elektrische Kontaktierung zwischen den Elektrodenschichten des Detektorelements und der Ausleseschaltung herzustellen. Dazu weist in einer besonderen Ausgestaltung der Stoffschluss einen elektrisch leitfähigen Stoff auf. Dies betrifft insbesondere den Stoffschluss zwischen dem Schaltungsträger und Detektorträger. Aber auch ein Stoffschluss mit einem elektrisch leitfähigen Stoff kann zwischen der Abdeckung und dem Detektorträger vorteilhaft sein, wenn in der Abdeckung Verdrahtungsbestandteile für das Detektorelement integriert sind.

Prädestiniert für die Herstellung des Stoffschlusses ist die so genannte "Flip-Chip"-Technik. Darunter wird ein Montageverfahren aus dem Bereich der Aufbau und Verbindungstechnik (AVT) verstanden, die sich vor allen Dingen in der Mikroelektronik zur Kontaktierung von Halbleiter-Mikrochips oder von integrierten Schaltungen in ungehäuster Form bewährt hat. Bei der Flip-Chip-Technik wird ein Chip direkt, ohne weitere Anschlussdrähte, mit einer aktiven Kontaktierungsseite nach unten zum Substrat (Schaltungsträger) hin montiert. Eine Montage erfolgt über sogenannte "Bumps" aus elektrisch leitendem Material. Dies führt zu sehr kurzen Leiterlängen. Dies wird bei der vorliegenden Erfindung ausgenutzt: Es resultiert ein kompakter Aufbau. Durch die sehr kurzen Leiterlängen werden zudem unerwünschte, das auszulesende elektrische Signal störende Streuinduktivitäten und -kapazitäten auf ein Mindestmaß reduziert. Dieser Einfluss wirkt sich insbesondere vorteilhaft bei einer relativ kleinen Anzahl von zu kontaktierenden Detektorelementen aus. Mit Hilfe der Flip-Chip-Technik kann zudem eine Vielzahl von elektrischen Verbindungen gleichzeitig hergestellt werden, was einen enormen Zeit- und damit Kostenvorteil mit sich bringt.

Zur Realisierung der "Flip-Chip"-Technik und damit zum Herstellen des Stoffschlusses können verschiedene Techniken eingesetzt werden. In einer besonderen Ausgestaltung wird zum Herstellen des Stoffschlusses ein aus der Gruppe Kleben, Löten und/oder Bonden ausgewähltes Verfahren durchgeführt. Dabei sind adhäsives Bonden oder eutektisches Bonden denkbar. Zum Löten werden Bumps aus einem Lot (Lotkugeln) auf einem oder auf beide miteinander zu verbindenden Träger bzw. Bestandteile der Vorrichtung aufgebracht. Die genannten Verfahren sind an sich gegenüber dem Kleben zu bevorzugen, da es bei einem Klebstoff zu Ausgasungen von organischen Bestandteilen (Lösungsmittel, Klebstoffkomponente,...) kommen kann. Dies spielt insbesondere im Hinblick auf die Evakuierung der Stapelhohlräume eine Rolle. Nichtsdestotrotz kann es aber notwendig oder vorteilhaft sein, auf das Kleben zurückzugreifen.

Beim Kleben kann auf verschiedene Varianten zurückgegriffen werden: Das Kleben kann mit einem elektrisch nicht leitfähigem Klebstoff erfolgen. Dazu sind auf Kontaktflächen des entsprechenden Trägers Bumps aufgebracht. Die Bumps bestehen beispielsweise aus Aluminium oder Gold. Danach wird auf den Träger eine Klebstoffschicht des Klebstoffs aufgetragen und das entsprechende Gegenstück auf der Klebstoffschicht angeordnet. Beim Trocknen schrumpft der Klebestoff und es bilden sich die elektrischen Kontakte.

Ebenso kann zum Kleben ein isotrop leitfähiger Klebstoff verwendet werden. Auf die Kontaktflächen eines Trägers wird leitfähiger Klebstoff aufgebracht. Danach wird das Gegenstück mit seinen Kontaktflächen auf die Klebepunkte gesetzt. Der Klebstoff kann thermisch oder mittels UV-Strahlung ausgehärtet werden und stellt so den elektrisch leitfähigen Stoffschluss her.

Alternativ dazu wird ein anisotrop leitfähiger Klebstoff verwendet. Anisotrop leitfähiger Klebstoff ist ein Verbundmaterial aus elektrisch nicht leitfähigem Klebstoff und darin mit geringem Füllgrad enthaltenen, elektrisch leitfähigen Partikeln. Der anisotrop leitfähige Klebstoff wird auf den Kontaktflächen des Trägers aufgetragen. Durch den geringen Füllgrad stehen die elektrisch leitfähigen Partikel nach dem Auftragen nicht in Verbindung zueinander. Es bildet sich keine elektrisch leitfähige Verbindung. Beim Aufsetzen des Gegenstücks wird der elektrisch nicht leitfähige Klebstoff verdrängt, bis die Partikel zwischen den Kontaktflächen des Trägers und den Kontaktflächen des Gegenstücks eingeklemmt werden und eine elektrisch leitfähige Verbindung zwischen den Kontaktflächen entsteht.

Gemäß einer besonderen Ausgestaltung des Verfahrens werden während und/oder nach dem festen Verbinden der erste Stapelhohlraum und/oder der zweite Stapelhohlraum evakuiert. Beispielsweise erfolgt das Herstellen des Stoffschlusses zwischen den Bestandteilen des Stapels im Vakuum. Mit der Ausbildung des Stoffschlusses wird der jeweilige Stapelhohlraum evakuiert. Denkbar ist auch, dass die Stapelhohlräume zunächst hergestellt und im Nachhinein evakuiert werden. Auch hier gilt: Die Stapelhohlräume können nacheinander oder gleichzeitig evakuiert werden. Zum gleichzeitigen Evakuieren können die Stapelhohlräume isobar miteinander verbunden sein. Dies bedeutet, dass der Druck in den beiden Stapelhohlräumen gleich ist.

Die Vorrichtung kann ein einziges Detektorelement aufweisen. Im Hinblick auf eine Anwendung der Vorrichtung als Präsenzmelder oder insbesondere als Wärmebildkamera ist es aber vorteilhaft bzw. notwendig, dass mehrere Detektorelemente vorhanden sind. In einer besonderen Ausgestaltung ist daher mindestens ein Detektorarray mit mehreren Detektorelementen vorhanden. Ein Detektorelement ist dabei ein Pixel des Detektorarrays. Das Detektorarray zeichnet sich beispielsweise durch eine spalten-und/oder zeilenförmige Anordnung der Detektorelemente aus. Bei einer zeilenförmigen oder spaltenförmigen Anordnung sind die Detektorelemente eindimensional in einer Richtung verteilt. Bei einer spalten- und zeilenförmigen Anordnung liegt eine zweidimensionale Verteilung vor. Das Detektorarray besteht beispielsweise aus 240 x 320 einzelnen Elementen. Dies entspricht dem relativ niedrigen Auflösungsstandard QVGA. Denkbar ist übrigens auch eine willkürliche, flächige Verteilung der Detektorelemente. Für jedes der Detektorelemente kann ein eigenes Bestrahlungsfenster vorgesehen sein. Vorteilhaft ist aber, dass die Vorrichtung ein einziges Bestrahlungsfenster für mehrere oder für alle Detektorelemente aufweist. Damit kann die Herstellung der Vorrichtung vereinfacht werden.

Gemäß einer weiteren Ausgestaltung weist der Stapel eine Umhüllung auf. Der Stapel wird in einer Umhüllung angeordnet. Die Umhüllung schützt den Stapel mit seinen Bestandteilen vor schädlichen Umwelteinflüssen, beispielsweise Feuchtigkeit, oder vor mechanischer Zerstörung. Zu beachten ist dabei lediglich, dass die Bestrahlung des Detektorelements durch die Umhüllung nicht beeinträchtigt wird. Dazu wird ein Bestrahlungsfenster mit hoher Transmission für die Wärmestrahlung in die Umhüllung integriert.

Die Umhüllung kann dabei ein Gehäuse aus einem beliebigen Material sein. Vorzugsweise ist die Umhüllung eine Vergussmasse. Dazu wird zum Anordnen der Umhüllung ein aus der Gruppe Spritzgussverfahren oder Moldverfahren ausgewähltes Verfahren durchgeführt. Diese Verfahren sind aus Kostengründen besonders vorteilhalt. Dabei wird un- oder teilvernetzter Kunststoff auf den Stapel aufgebracht. Nach dem Auftragen wird der Kunststoff thermisch induziert oder durch Bestrahlung mit UV-Licht ausgehärtet. Zur Integration des Bestrahlungsfensters wird beispielsweise eine Maske benutzt, die nach dem Anordnen des Kunststoffs oder nach dem Aushärten des Kunststoffs entfernt wird. Dies gelingt beispielsweise durch Transfermolden mit einem gefederten Insert. Denkbar ist auch die Verwendung eines Bestrahlungsfensters aus einem Material mit hoher Transmission für die Wärmestrahlung, die nach dem Auftragen und Aushärten des Kunststoffs in der Umhüllung verbleibt.

Mit dem beschriebenen Verfahren kann eine einzige Vorrichtung zur Detektion von Wärmestrahlung hergestellt werden. Vorteilhaft werden aber mehrere Vorrichtungen gleichzeitig, also parallel hergestellt. Die Herstellung erfolgt im Nutzen. In einer besonderen Ausgestaltung wird daher eine Vielzahl von Vorrichtungen zur Detektion von Wärmestrahlung auf Wafer-Ebene hergestellt. Nach dem Herstellen wird ein Vereinzeln der Vorrichtungen bzw. der Stapel der Vorrichtungen durchgeführt. Es werden die drei Träger, also Detektorträger, Schaltungsträger und Abdeckung als Wafer, insbesondere als Silizium-Wafer mit jeweils einer Vielzahl von entsprechenden Bestandteilen und Funktionalitäten zu einer oben beschriebenen Sandwichstruktur zusammengebracht. Nach dem Zusammenbringen und vorteilhaft vor dem Anordnen der Umhüllungen werden die Stapel voneinander getrennt. Das Trennen bzw. Vereinzeln geschieht beispielsweise durch Sägen, durch Erodieren oder durch ähnliche Verfahren. Nach dem Vereinzeln wird an die Stapel der Vorrichtungen jeweils eine Umhüllung angebracht.

Gemäß einem weiteren Aspekt der Erfindung wird die Vorrichtung als Bewegungsmelder, als Präsenzmelder oder als Wärmebildkamera verwendet. Für einen Bewegungsmelder kann eine Vorrichtung mit einem einzigen Detektorelement ausreichend sein. Für einen Präsenzmelder kann die Vorrichtung mit mehreren Detektorelementen ausgestattet sein. Für die Wärmebildkamera ist die Vorrichtung mit einer Vielzahl von Detektorelementen, beispielsweise 240 X 320 Detektorelemente (QVGA-Standard) und mehr ausgestattet. Dies ist durch die einfache und Platz sparende Verdrahtung der Detektorelemente möglich.

Zusammenfassend sind folgende Vorteile der Erfindung hervorzuheben:
- Die Vorrichtung zur Detektion von Wärmestrahlung ist kompakt.
- Durch die Sandwichbauweise kann eine Vielzahl von Detektorelementen Platz sparend kontaktiert werden.
- Die elektrischen Leitungen zwischen den Elektroden eines Detektorelements und dem zugeordneten Ausleseschaltkreis bzw. Ausleseelement sind kurz. Induktivitäten und Kapazitäten, die zu Störsignalen führen und damit die Detektvität des Detektorelements beeinflussen könnten, sind im Vergleich zu Bonddrähten deutlich reduziert.
- Durch die Art der Kontaktierung ist ein hohes Maß an Parallelisierung bei der Herstellung möglich.
- Durch den hermetischen Stoffschluss sind die zur Verbesserung der Empfindlichkeit der Vorrichtung und zum Schutz des Detektorelements beitragenden evakuierbaren Stapelhohlräume einfach zugänglich.

Anhand mehrerer Ausführungsbeispiele und der dazugehörigen Figuren wird im Folgenden eine Vorrichtung zur Detektion von Wärmestrahlung vorgestellt. Die Figuren sind schematisch und stellen keine maßstabsgetreuen Abbildungen dar.
- Figur 1: zeigt eine Vorrichtung zur Detektion von Wärmestrahlung in einem seitlichen Querschnitt.
- Figur 2A: zeigt die Vorrichtung zur Detektion von Wärmestrahlung aus Figur 1 entlang der Querschnittsflächen B-B in Aufsicht auf die Abdeckung.
- Figur 2B: zeigt die Vorrichtung zur Detektion von Wärmestrahlung aus Figur 1 entlang der Querschnittsflächen A-A in Aufsicht auf den Detektorträger
- Figur 2C: zeigt die Vorrichtung zur Detektion von Wärmestrahlung aus Figur 1 entlang der Querschnittsflächen A-A in Aufsicht auf den Schaltungsträger.
- Figur 3: zeigt ein Detektorelement auf einem Detektorträger in einem seitlichen Querschnitt.

Die Vorrichtung 1 zur Detektion von Wärmestrahlung weist einen Stapel 10 mit einem Detektorträger 11 mit einem Detektorarray 110 von thermischen Detektorelement 111 zur Umwandlung der Wärmestrahlung in elektrisches Signale, einem Schaltungsträger 12 mit einer Ausleseschaltung 121 zum Auslesen der elektrischen Signale, und mindestens einer Abdeckung 13 zum Abdecken der Detektorelemente, wobei der Detektorträger und die Abdeckung derart aneinander angeordnet sind, dass zwischen den Detektorelementen des Detektorträgers und der Abdeckung ein, vom Detektorträger und von der Abdeckung begrenzter, erster Stapelhohlraum 14 des Stapels vorhanden ist, der Schaltungsträger und der Detektorträger derart aneinander angeordnet sind, dass zwischen dem Detektorträger und dem Schaltungsträger mindestens ein, vom Schaltungsträger und vom Detektorträger begrenzter, zweiter Stapelhohlraum 15 des Stapels vorhanden ist und der erste Stapelhohlraum und/oder der zweite Stapelhohlraum evakuiert sind.

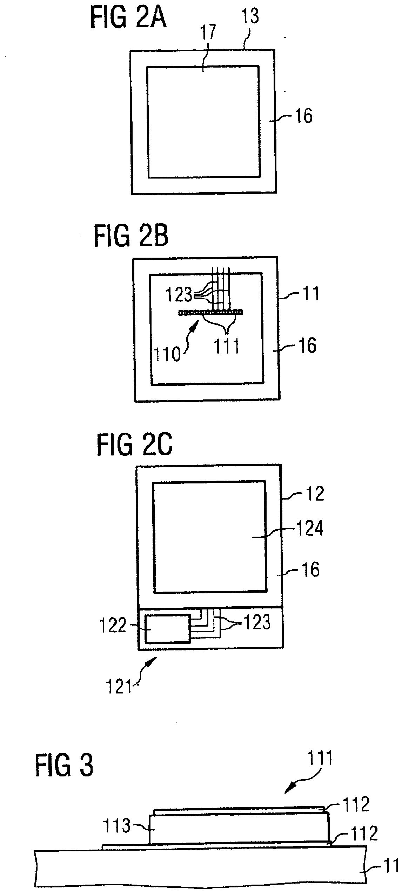

Die Detektorelemente sind pyroelektrische Detektorelemente in Dünnschichtbauweise mit zwei Elektrodenschichten 112 und einer zwischen den Elektrodenschichten angeordneten pyroelektrischen Schicht 113 (Figur 3). Die pyroelektrische Schicht ist eine ca. 1 µm dicke Schicht aus PZT als pyroelektrisch sensitives Material. Die Elektrodenschichten sind aus Platin und einer Chrom-Nickel-Legierung mit Schichtdicken von etwa 20 nm.

Die Auslesschaltung weist ein auf dem Schaltungsträger angeordnetes Ausleseelement 122 in Form eines ASICs auf. Gemäß einer nicht dargestellten Ausführungsform ist das Ausleselement im Schaltungsträger integriert.

Der Detektorträger, der Schaltungsträger und die Abdeckung sind jeweils Siliziumsubstrate. Die Detektorelemente sind innerhalb des zweiten Stapelhohlraums gegenüber einer Schaltungsträgerausnehmung 124 des Schaltungsträgers angeordnet. Im Bereich der Schaltungsträgerausnehmung ist ein gemeinsames Bestrahlungsfenster 17 angeordnet, durch das die Wärmestrahlung auf Detektorelemente gelangt. Die Bestrahlung erfolgt von der Vorderseite aus. Gemäß einer nicht dargestellten alternativen Ausgestaltung erfolgt die Bestrahlung von der Rückseite aus. Dazu ist in der Abdeckung und im Detektorträger jeweils ein geeignetes Bestrahlungsfenster ausgebildet.

In der Abdeckung 14 ist eine Abdeckungsausnehmung 131 vorhanden.

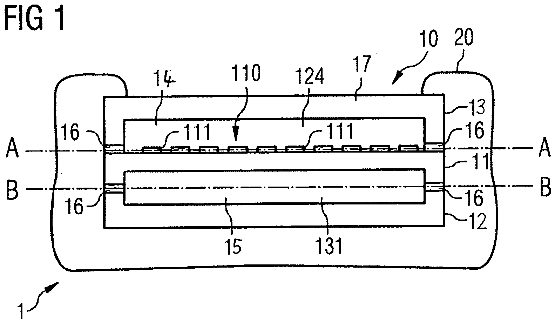

Diese Abdeckungsausnehmung kann aber auch weggelassen werden, wie es in Figur 1 durch die strichlierten Linie angedeutet ist.

Sowohl der Detektorträger und die Abdeckung als auch der Detektorträger und der Schaltungsträger sind durch einen hermetischen Stoffschluss 16 fest miteinander verbunden. Gemäß einer ersten Ausführungsform besteht der Stoffschluss aus einem Lot. Die Träger (Siliziumsubstrate) sind miteinander verlötet. Alternativ dazu weist der Stoffschluss einen Klebstoff auf. Die Träger sind zusammengeklebt.

Durch den Stoffschluss zwischen dem Schaltungsträger und dem Detektorträger ist für eine elektrische Verdrahtung 123 der Detektorelemente gesorgt. Über die Verdrahtung bzw. über die Ausleseschaltung werden die elektrischen Signale der Detektorelemente ausgelesen. Alternativ dazu erfolgt die Verdrahtung mittels Flip-Chip.

Während des Herstellens der Stoffschlüsse wird Vakuum angelegt, so dass sich ein Unterdruck in den entstehenden Stapelhohlräumen ausbildet. Die Stapelhohlräume werden bei deren Bildung evakuiert. Alternativ dazu werden die Stapelhohlräume nach dem Herstellen der Stoffschlüsse evakuiert.

Nach dem Herstellen des Stapels wird der Stapel mit einer Umhüllung 20 versehen. Dazu wird ein unvernetzter Kunststoff in einem Spritzgussverfahren auf den Stapel aufgetragen und anschließend vernetzt. Alternativ dazu wird ein Moldverfahren durchgeführt. Dabei wird dafür gesorgt, dass das Bestrahlungsfenster der Abdeckung frei bleibt, also nicht bedeckt wird.

Zum Herstellen der Vorrichtung werden der Detektorträger mit dem Detektorarray, der Schaltungsträger mit der Ausleseschaltung und die Abdeckung bereitgestellt und wie oben beschrieben fest miteinander verbunden. Das Herstellen erfolgt dabei auf Wafer-Ebene. Dazu werden Silizium-Wafer mit einer Vielzahl von entsprechenden Funktionalitäten (Detektorarrays, Ausleseschaltungen, Abdeckungsausnehmungen) versehen. Es werden auf Wafer-Ebene Detektorträger, Schaltungsträger und Abdeckung bereitgestellt. Diese funktionalisierten Silizum-Wafer werden wie oben beschrieben fest miteinander verbunden. Es wird ein Wafer-Stapel mit einer Vielzahl von Einzel-Stapeln hergestellt. Nach dem Verbinden werden die Einzel-Stapel durch Zersägen des Wafer-Stapels vereinzelt und mit jeweils einer Umhüllung versehen.

Verwendung findet die Vorrichtung in einem Bewegungsmelder oder Präsenzmelder. Für die Anwendung in einer Wärmebildkamera ist eine Vielzahl Stapeln bzw. von Vorrichtungen mit jeweils einem Stapel vorhanden.

## Patentansprüche

1. Vorrichtung (1) zur Detektion von Wärmestrahlung, aufweisend einen Stapel (10) mit
- mindestens einem Detektorträger (11) mit mindestens einem thermischen Detektorelement (111) zur Umwandlung der Wärmestrahlung in ein elektrisches Signal,
- mindestens einem Schaltungsträger (12) mit mindestens einer Ausleseschaltung (121, 122) zum Auslesen des elektrischen Signals, wobei die Ausleseschaltung (121, 122) durch CMOS-Technik direkt im Schaltungsträger (12) integriert ist, und
- mindestens einer Abdeckung (13) zum Abdecken des Detektorelements,
wobei
- jeweils ein Silizium-Substrat als die Abdeckung (13), als der Schaltungsträger (12) und als der Detektorträger (11) verwendet ist,
- der Detektorträger zwischen dem Schaltungsträger und der Abdeckung angeordnet ist und der Stapel (10) eine Sandwich-Struktur aus dem Detektorträger (11), dem Schaltungsträger (12) und der Abdeckung (13) hat,
- der Detektorträger und die Abdeckung derart aneinander angeordnet sind, dass zwischen dem Detektorelement des Detektorträgers und der Abdeckung mindestens ein, vom Detektorträger und von der Abdeckung begrenzter, erster Stapelhohlraum (14) des Stapels vorhanden ist,
- der Schaltungsträger und der Detektorträger derart aneinander angeordnet sind, dass zwischen dem Detektorträger und dem Schaltungsträger mindestens ein, vom Schaltungsträger und vom Detektorträger begrenzter, zweiter Stapelhohlraum (15) des Stapels vorhanden ist und
- der Detektorträger und der Schaltungsträger und/oder der Detektorträger und die Abdeckung jeweils durch einen hermetischen Stoffschluss (16) fest miteinander verbunden sind, so dass der erste Stapelhohlraum und/oder der zweite Stapelhohlraum evakuiert sind.

2. Vorrichtung nach Anspruch 1, wobei der Detektorträger, der Schaltungsträger und/oder die Abdeckung mindestens ein Bestrahlungsfenster (17) mit einer bestimmten Transmission für die Wärmestrahlung zum Bestrahlen des Detektorelements mit der Wärmestrahlung aufweisen.

3. Vorrichtung nach Anspruch 1 oder 2, wobei der Detektorträger, der Schaltungsträger und/oder die Abdeckung Silizium aufweisen.

4. Vorrichtung nach einem der Ansprüche 1 bis 3, wobei das Detektorelement gegenüber einer Schaltungsträgerausnehmung (124) des Schaltungsträgers oder gegenüber einer Abdeckungsausnehmung (131) der Abdeckung angeordnet ist.

5. Vorrichtung nach einem der Ansprüche 1 bis 4, wobei der Stoffschluss einen elektrisch leitfähigen Stoff aufweist.

6. Vorrichtung nach einem der Ansprüche 1 bis 5, wobei mindestens ein Detektorarray (110) mit mehreren Detektorelementen vorhanden ist.

7. Verfahren zum Herstellen einer Vorrichtung zur Detektion von Wärmestrahlung mit folgenden Verfahrensschritten:
a) Bereitstellen
- mindestens eines Detektorträgers (11) mit mindestens einem thermischen Detektorelement (111) zur Umwandlung der Wärmestrahlung in ein elektrisches Signal,
- Bereitstellen mindestens eines Schaltungsträgers (12) mit mindestens einer Ausleseschaltung (121) zum Auslesen des elektrischen Signals, wobei die Ausleseschaltung (121, 122) durch CMOS-Technik direkt im Schaltungsträger (12) integriert ist, und
- Bereitstellen mindestens einer Abdeckung (13) zum Abdecken des Detektorelements, wobei jeweils ein Silizium-Substrat als die Abdeckung (13), als der Schattungsträger (12) und als der Detektorträger (11) verwendet wird,
b) festes Verbinden des Detektorträgers, des Schaltungsträgers und der Abdeckung zu einem Stapel (10), wobei
- der Detektorträger zwischen dem Schaltungsträger und der Abdeckung angeordnet wird, wobei der Stapel (10) eine Sandwich-Struktur aus dem Detektorträger (11), dem Schattungsträger (12) und der Abdeckung (13) hat und zum festen Verbinden des Detektorträgers und des Schaltungsträgers und/oder zum festen Verbinden des Detektorträgers und der Abdeckung ein hermetischer Stoffschluss hergestellt wird,
- der Detektorträger und die Abdeckung derart aneinander angeordnet sind, dass zwischen dem Detektorelement des Detektorträgers und der Abdeckung mindestens ein, vom Detektorträger und von der Abdeckung begrenzter, erster Stapelhohlraum (14) des Stapels vorhanden ist,
- der Schaltungsträger und der Detektorträger derart aneinander angeordnet sind, dass zwischen dem Detektorträger und dem Schaltungsträger mindestens ein, vom Schaltungsträger und vom Detektorträger begrenzter, zweiter Stapelhohlraum (15) des Stapels vorhanden ist und
- der erste Stapelhohlraum und/oder der zweite Stapelhohlraum evakuiert sind.

8. Verfahren nach Anspruch 7 wobei zum Herstellen des Stoffschlusses ein aus der Gruppe Kleben, Löten und/oder Bonden ausgewähltes Verfahren durchgeführt wird.

9. Verfahren nach einem der Ansprüche 7 und 8, wobei während und/oder nach dem festen Verbinden der erste Stapelhohlraum und/oder der zweite Stapelhohlraum evakuiert werden.

10. Verfahren nach einen der Ansprüche 7 bis 9, wobei an den Stapel eine Umhüllung (20) angeordnet wird.

11. Verfahren nach Anspruch 10, wobei zum Anordnen der Umhüllung ein aus der Gruppe Spritzgussverfahren oder Moldverfahren ausgewähltes Verfahren durchgeführt wird.

12. Verfahren nach einem der Ansprüche 7 bis 11, wobei eine Vielzahl von Vorrichtungen zur Detektion von Wärmestrahlung auf Nafer-Ebene hergestellt wird und nach dem Herstellen ein Vereinzeln der Vorrichtungen durchgeführt wird.

13. Verwendung einer Vorrichtung nach einem der Anspruche 1 bis 6 als Bewegungsmelder, Präsenzmelder und/oder als Wärmebildkamera.

## Claims

1. Device (1) for detecting thermal radiation, comprising a stack (10) with
- at least one detector support (11) having at least one thermal detector element (111) for the conversion of the thermal radiation into an electric signal,
- at least one circuit support (12) with at least one read-out circuit (121, 122) to read out the electric signal, wherein the read-out circuit (121, 122) is directly integrated in the circuit support (12) by the application of CMOS technology, and
- at least one cover (13) to shield the detector element, wherein
- silicon substrates are respectively used for the cover (13), the circuit support (12) and the detector support (11)
- the detector support is arranged between the circuit support and the cover and the stack (10) has a sandwich-structure comprising the detector support (11), the circuit support (12) and the cover (13),
- the detector support and the cover are so arranged against each other that at least one first stack cavity (14) of the stack bounded by the detector support and the cover is provided between the detector element of the detector support and the cover
- the circuit support and the detector support are so arranged against each other that at least one second stack cavity (15) bounded by the circuit support and the detector support is provided between the detector support and the circuit support, and
- the detector support and the circuit support and/or the detector support and the cover are respectively connected by a hermetically-sealed permanent material bond (16) such that the first stack cavity and/or the second stack cavity are evacuated.

2. Device according to claim 1, wherein the detector support, the circuit support and/or the cover comprise at least one radiation window (17) with a specific transmission capacity for the thermal radiation to irradiate the detection element with the thermal radiation.

3. Device according to claim 1 or 2, wherein the detector support, the circuit support and/or the cover comprise silicon.

4. Device according to any of claims 1 to 3, wherein the detector element is arranged opposite to an aperture (124)in the circuit support or opposite to an aperture (131) in the cover.

5. Device according to any of claims 1 to 4, wherein the permanent material bond comprises an electrically-conductive material.

6. Device according to any of claims 1 to 5, wherein at least one detector array (110) with several detector elements is provided.

7. Method for producing a device for detecting of thermal radiation comprising the following procedural steps:
a) Provision of
- at least one detector support (11) with at least one thermal detector element (111) to convert thermal radiation into an electric signal,
- provision of at least one circuit support (12) with at least one read-out circuit (121) to read out the electric signal, wherein the read-out circuit (121, 122) is directly integrated in the circuit support (12) by the application of CMOS technology, and
- provision of at least one cover (13) to shield the detector element, wherein
b) firm bonding of the detector support, the circuit support and the cover to form a stack (10), wherein
- the detector support is arranged between the circuit support and the cover, wherein the stack (10) has a sandwich-structure comprising the detector support (11), the circuit support (12) and the cover (13) and a hermetically-sealed permanent bond for the firm bonding of the detector support and the circuit support and/or for the firm bonding of the detector support and the cover is manufactured,
- the detector support and the cover are so arranged against each other that a first stack cavity (14) bounded by the detector support and the cover is provided between the detector element of the detector support and the cover,
- the circuit support and the detector support are so arranged against each other that at least one second stack cavity (15) bounded by the circuit support and the detector support is provided between the circuit support and the detector support and
- the first stack cavity and/or the second stack cavity are evacuated.

8. Method according to claim 7, wherein a method is selected from the group comprising adhesion-, soldering- and/or bonding technology to manufacture a permanent material bond.

9. Method according to any of claims 7 to 8, wherein during and/or after the firm bonding activity the first stack cavity and/or the second stack cavity is evacuated.

10. Method according to any of claims 7 to 9, wherein a casing (20) is arranged around the stack.

11. Method according to claim 10, wherein a method is selected from the group comprising injection moulding or moulding to place the casing in position.

12. Method according to any of claims 7 to 11, wherein a number of devices for the detection of thermal radiation are manufactured at wafer-level and that, when the manufacture has been completed, the individual devices are separated from one another.

13. Use of a device according to any of claims 1 to 6 as a motion detector, a presence detector and/or as a thermal imaging camera.

## Revendications

1. Dispositif de détection (1) de rayonnement thermique, comprend un empilage (10) avec
- au moins un support de détecteur (11) avec au moins un élément détecteur thermique (111) permettant de convertir le rayonnement thermique en un signal électrique,
- au moins un support de circuit (12) avec au moins un circuit de lecture (121, 122) permettant de lire le signal électrique, moyennant quoi le circuit de lecture (121, 122) est intégré directement dans le support de circuit (12) en technique CMOS et
- au moins une protection (13) permettant de recouvrir l'élément détecteur,
moyennant quoi
- un substrat de silicium est utilisé en tant que protection (13), que support de circuit (12) et que support de détecteur (11),
- le support de détecteur est disposé entre le support de circuit et le recouvrement et l'empilage (10) présente une structure en sandwich constituée du support de détecteur (11), le support de circuit (12) et la protection (13),
- le support de détecteur et la protection sont disposés l'un sur l'autre de telle sorte qu'il existe, entre l'élément détecteur du support de détecteur et la protection, au moins un premier espace creux (14) de l'empilage, limité par le support de détecteur et par la protection,
- le support de circuit et le support de détecteur sont disposés l'un par rapport à l'autre de telle sorte qu'il existe, entre le support de détecteur et le support de circuit, au moins un deuxième espace creux (15) de l'empilage, limité par le support de circuit et le support de détecteur, et
- le support de détecteur et le support de circuit et/ou le support de détecteur et la protection sont reliés solidement par une liaison de matière hermétique (16) de façon à ce que le premier espace creux d'empilage et/ou le deuxième espace creux d'empilage soient évacués.

2. Dispositif selon la revendication 1, moyennant quoi le support de détecteur, le support de circuit et/ou la protection comportent au moins une fenêtre de rayonnement (17) avec un taux de transmission déterminé pour le rayonnement thermique pour l'irradiation de l'élément détecteur avec le rayonnement thermique.

3. Dispositif selon la revendication 1 ou 2, moyennant quoi le support de détecteur, le support de circuit et/ou la protection contiennent du silicium.

4. Dispositif selon l'une des revendications 1 à 3, moyennant quoi l'élément détecteur est disposé en face d'un évidement de support de circuit (124) du support de circuit ou en face d'un évidement de protection (131) de la protection.

5. Dispositif selon l'une des revendications 1 à 4, moyennant quoi la liaison de matière comprend une matière électro-conductrice.

6. Dispositif selon l'une des revendications 1 à 5, moyennant quoi il comprend au moins un ensemble de détecteurs (110) avec plusieurs éléments détecteurs.

7. Procédé de fabrication d'un dispositif de détection de rayonnement thermique comprenant les étapes suivantes :
a) Mise en place
- d'au moins un support de détecteur (11) avec au moins un élément détecteur thermique (111) permettant de convertir le rayonnement thermique en un signal électrique,
- mise en place d'au moins un support de circuit (12) avec au moins un circuit de lecture (121) permettant de lire le signal électrique, moyennant quoi le circuit de lecture (121, 122) est intégré directement dans le support de circuit (12) en technique CMOS, et
- mise en place d'au moins une protection (13) permettant de recouvrir l'élément détecteur, moyennant quoi un substrat de silicium est utilisé en tant que protection (13), support de circuit (12) et support de détecteur (11),
b) liaison solide du support de détecteur, du support de circuit et de la protection en un empilage (10), moyennant quoi
- le support de détecteur est disposé entre le support de circuit et la protection, moyennant quoi l'empilage (10) présente une structure en sandwich constituée du support de détecteur (11), du support de circuit (12) et de la protection (13) et une liaison de matière hermétique est réalisée pour une liaison solide entre le support de détecteur et le support de circuit et/ou pour une liaison solide entre le support de détecteur et la protection,
- le support de détecteur et la protection sont disposés l'un par rapport à l'autre de telle sorte que, entre l'élément détecteur du support de détecteur et la protection se trouve au moins un premier espace creux (14) d'empilage, limité par le support de détecteur et la protection,
- le support de circuit et le support de détecteur sont disposés l'un par rapport à l'autre de telle sorte que, entre le support de détecteur et le support de circuit se trouve au moins un deuxième espace creux (15) d'empilage, limité par le support de circuit et le support de détecteur, et
- le premier espace creux d'empilage et/ou le deuxième espace creux d'empilage sont évacués.

8. Procédé selon la revendication 7, moyennant quoi, pour la réalisation de la liaison de matière, le procédé utilisé est choisi parmi le collage, le brasage et/ou la fixation.

9. Procédé selon l'une des revendications 7 et 8, moyennant quoi pendant et/ou après la liaison solide, le premier espace creux d'empilage et/ou le deuxième espace creux d'empilage sont évacués.

10. Procédé selon l'une des revendications 7 à 9, moyennant quoi sur l'empilage se trouve un enrobage (20).

11. Procédé selon la revendication 10, moyennant quoi pour la réalisation de l'enrobage, le procédé utilisé peut être choisi dans le groupe constitué d'un procédé à injection et d'un procédé de moulage.

12. Procédé selon l'une des revendications 7 à 11, moyennant quoi une pluralité de dispositifs est réalisée pour la détection de rayonnement thermique sur une tranche et, après la réalisation, une séparation des dispositifs est effectuée.

13. Utilisation d'un dispositif selon l'une des revendications 1 à 6 en tant que capteur de mouvement, capteur de présence et/ou caméra à imagerie thermique.
